# EUROPÄISCHE PATENTSCHRIFT

(11) **EP 1 050 078 B1**
(45) Veröffentlichungstag und Bekanntmachung des Hinweises auf die Patenterteilung: **17.04.2002**
(21) Anmeldenummer: 98904120.7
(22) Anmeldetag: 22.01.1998
(51) Int. Cl.: H01L 23/538, H01L 21/98

(54) **MIKROSYSTEM UND VERFAHREN ZUM HERSTELLEN EINES MIKROSYSTEMS**
MICROSYSTEM AND METHOD FOR THE PRODUCTION THEREOF
MICROSYSTEME ET PROCEDE DE PRODUCTION D'UN MICROSYSTEME

(43) Veröffentlichungstag der Anmeldung: 08.11.2000
(73) Patentinhaber: Fraunhofer-Gesellschaft zur Förderung der angewandten Forschung e.V., 80636 München (DE)
(72) Erfinder: TRIEU, Hoc, Khiem, D-47057 Duisburg (DE); MOKWA, Wilfried, D-47800 Krefeld (DE); EWE, Lutz, D-47166 Duisburg (DE)
(74) Vertreter: Schoppe, Fritz, Dipl.-Ing.
(86) Internationale Anmeldenummer: EP9800344
(87) Internationale Veröffentlichungsnummer: WO9938211

(56) Entgegenhaltungen:
- EP-A- 0 189 976
- WO-A-98/02921
- US-A- 5 324 687

## Beschreibung

Die vorliegende Erfindung bezieht sich auf Mikrosysteme und Verfahren zum Herstellen von Mikrosystemen. Insbesondere bezieht sich die vorliegende Erfindung auf flexible Mikrosysteme, die in nahezu jede gewünschte Form gebracht werden können.

Aufgrund rasanter Fortschritte in der Siliziumtechnologie werden immer häufiger ganze Mikrosysteme in Silizium integriert. Diese modernen Mikrosysteme umfassen neben der Auswerteelektronik für eine Sensoranordnung auch die Sensoren bzw. Aktoren selbst, die ebenfalls mittels mikromechanischer Technologien in beispielsweise einem Siliziumsubstrat gebildet sind. Solche Mikrosysteme werden derzeit meistens aus Substraten aus einkristallinem Silizium hergestellt. Die elektrischen Eigenschaften von monokristallinem Silizium erlauben die Integration derartiger komplexer Schaltungen. Zur Realisierung von Sensorelementen bzw. Aktorelementen werden neben den elektrischen Eigenschaften die mechanischen Eigenschaften des Siliziums als Werkstoff selbst genutzt. Weitere alternativ anwendbare elektronische Werkstoffe, wie z. B. amorphes oder polykristallines Silizium, oder auch leitende Polymere, erreichen nicht annähernd ein zu monokristallinem Silizium vergleichbares elektrisches Verhalten.

Aufgrund der hohen mechanischen Härte von Silizium sind verwendete Substrate für bekannte Mikrosysteme aus massivem Silizium und daher starr und planar. Die Waferdicke liegt dabei in der Größenordnung von einigen Hundert Mikrometern. Dies ist der Grund, daß der Einsatz von solchen Mikrosystem-Chips in Umgebungen mit nicht-ebenen Auflageflächen ungeeignet sind. Der Nachteil einer fehlenden mechanischen Flexibilität macht sich mit zunehmender Chipfläche immer stärker bemerkbar. Es sei angemerkt, daß komplexe Mikrosysteme beträchtliche Chipflächen einnehmen können, wenn daran gedacht wird, daß neben einer integrierten Schaltung auch der Sensor bzw. Aktor selbst auf dem Wafer angeordnet ist.

US Patent Nr. 5 324 687 offenbart ein Mikrosystem mit einer Mehrzahl von Halbleiterelementen, welche in eine flexible Folie eingebettet sind, die von einem starren Substrat getragen wird.

Ein bekannter Ansatz zur Erhöhung der Flexibilität von Mikrosystemen ist in Trieu, H.K., Ewe, L., Mokwa, W.: *Flexible Mikrostrukturen in Silizium,* Fraunhofer IMS Jahresbericht 1996, S. 17 - 19, beschrieben. Zur Lösung des Flexibilitätsproblems werden mechanisch flexible MESAflex-Substrate vorgeschlagen, die aus einem Siliziuminselarray mit 0,8 bis 2 mm breiten und 0,3 bis 0,7 mm dicken Siliziuminseln bestehen, welche über dünne Siliziummembranen (Dicke < 20 µm) miteinander verbunden sind. Solche MESAflex-Substrate zeichnen sich durch eine wesentlich höhere Flexibilität im Vergleich zu herkömmlichen Mikrosystemen aus, die auf einem einzigen Siliziumwafer mit einer Dicke von mehreren Hundert Mikrometern integriert sind. Anordnungen derartiger Siliziuminseln erlauben lineare Auslenkungen von mehr als 90° aus der Hauptebene heraus. Allerdings sind diese einkristallinen Siliziummembranen, die die Siliziuminseln miteinander verbinden, für viele Anwendungszwecke immer noch zu empfindlich bzw. fragil. Ferner ist die lokale Flexibilität, d. h. die Flexibilität in einem bestimmten Bereich des Mikrosystems, durch die relativ großen Siliziuminseln begrenzt.

Die Aufgabe der vorliegenden Erfindung besteht darin, Mikrosysteme zu schaffen, die zuverlässig und dennoch hochflexibel sind.

Diese Aufgabe wird durch ein Mikrosystem gemäß Anspruch 1 sowie durch ein Verfahren zum Herstellen eines Mikrosystems gemäß Anspruch 16 gelöst.

Ein Mikrosystem gemäß der vorliegenden Erfindung umfaßt eine flexible Folie, eine Mehrzahl von Halbleiterelementen, die in der flexiblen Folie eingebettet sind, und zumindest eine im wesentlichen auf der flexiblen Folie angeordnete Verbindungsleitung zum elektrischen Verbinden von zumindest zwei Halbleiterelementen. Ein derartiges erfindungsgemäßes Mikrosystem zeichnet sich gegenüber dem Stand der Technik dadurch aus, daß Halbleiterelemente, welche integrierte Schaltungen oder aber auch Sensoren oder Aktoren sein können, nicht mehr über einen Wafer bzw. Siliziummembranen miteinander verbunden sind. Der Verzicht auf einen Wafer, der alle einzelnen Halbleiterelemente mechanisch verbindet und das Mikrosystem zu einem starren bzw. bei Verwendung von Siliziummembranen relativ brüchigen Gegenstand werden läßt, wird durch Verwendung einer flexiblen Folie ermöglicht, in die die Halbleiterelemente eingebettet sind. Die einzelnen Halbleiterelemente werden erfindungsgemäß lediglich von der flexiblen Folie getragen. Dadurch sind sie auch, wenn die flexible Folie isolierend ist, voneinander isoliert. Erfindungsgemäß kann dann auf die flexible Folie eine benötigte Struktur von Leiterbahnen bzw. Busleitungen aufgebracht werden, um die einzelnen Halbleiterelemente untereinander zu verbinden, um ein erwünschtes Mikrosystem zu erhalten.

Die Halbleiterelemente können allgemein betrachtet als flache Quader angesehen werden, welche auf mehrere Arten und Weisen in der flexiblen Folie eingebettet sein können. Zum einen ist es möglich, die Halbleiterelemente, welche lediglich Dicken von wenigen Mikrometern bzw. bis in den Submikrometerbereich haben, derart in der flexiblen Folie einzubetten, daß beide Hauptoberflächen der quaderförmigen Halbleiterelemente freiliegend sind. Eine Verbindungsleitung kann dann direkt auf Anschlußflächen eines Halbleiterelements aufgebracht werden. Es wird jedoch bevorzugt, die sehr dünnen Halbleiterelemente so in eine Folie einzubetten, daß lediglich die Rückseite der Halbleiterelemente freiliegend ist. Die Vorderseite der Halbleiterelemente, auf denen die Anschlußflächen angeordnet sind, sind dann ebenfalls von der flexiblen Folie bedeckt. Um Verbindungsleitungen herzustellen, ist es dann erforderlich, Kontaktlöcher in die flexible Folie einzubringen, um die Halbleiterelemente anzuschließen bzw. untereinander zu verbinden.

Erfindungsgemäß sind die einzelnen Halbleiterelemente mechanisch im wesentlichen durch die flexible Folie miteinander verbunden. Die Flexibilität des Mikrosystems ist daher nicht mehr durch die starren Halbleiterelemente bestimmt, sondern im wesentlichen durch die flexible Folie. Vorteilhafterweise existieren weitere Möglichkeiten, um die Flexibilität des Mikrosystems an bestimmte Gegebenheiten anzupassen, d. h. eine lokale Flexibilität des Mikrosystems einzustellen. So ist es möglich, durch bestimmtes Anordnen der Halbleiterelemente untereinander, beispielsweise in Funktionsblöcken, eine solche Flexibilität des Mikrosystems zu schaffen, daß dasselbe gefaltet oder auch gerollt werden kann. Vorteilhafterweise kann ferner die flexible Folie in bestimmten Bereichen durch beliebig geometrisch strukturierbare "Verstärkungs"-Stege modelliert werden, um beispielsweise ein relativ steifes Mikrosystem in x-Richtung, jedoch ein sehr flexibles Mikrosystem in y-Richtung zu schaffen. Diese Maßnahme erlaubt somit ebenfalls wie eine bestimmte Anordnung der Halbleiterelemente in der flexiblen Folie, das Herstellen einer lokalen Steifigkeit bzw. dem Gegenstück, einer lokalen Flexibilität des Mikrosystems.

Weiterhin besteht die Möglichkeit, die Eigenschaften der flexiblen Folie direkt zu beeinflussen, d. h. wenn als flexible Folie eine Polymerfolie verwendet wird, so kann durch unterschiedliche Aushärtbedingungen die Steifigkeit der Folie lokal eingestellt werden.

Das erfindungsgemäße Mikrosystem, bei dem die Halbleiterelemente in die flexible Folie eingebettet sind, hat im Vergleich zu bekannten flexiblen Schaltungen, bei denen Halbleiterchips auf einem flexiblen Substrat aufgelötet bzw. aufgeklebt sind, den Vorteil, daß durch ein Biegen des Mikrosystems vorhandene Belastungen im wesentlichen vollständig in der flexiblen Folie und nicht in dem Halbleiterelement aufgenommen werden, wodurch bei einer Verbiegung auftretende mechanische Spannungen nicht zu piezoresistiven Beeinflussungen der elektrischen Parameter der Halbleiterelemente führen. Obwohl das flexible Mikrosystem insgesamt nahezu an jede beliebige Form angepaßt werden kann bzw. in nahezu jede beliebige Form gebracht werden kann, halten die einzelnen Halbleiterelemente jeweils für sich ihre individuelle Struktur bei, d. h. sie werden nicht verbogen, was besonders bei bestimmten Sensoren oder Aktoren bedeutsam ist, deren mechanische Gestalt nicht "verzogen" werden darf.

Bevorzugte Ausführungsbeispiele der vorliegenden Erfindung werden nachfolgend bezugnehmend auf die beiliegenden Zeichnungen detaillierter erläutert. Es zeigen:
- Fig. 1: eine allgemeine schematische Darstellung eines erfindungsgemäßen Mikrosystems; und
- Fig. 2: eine Querschnittsdarstellung eines Mikrosystems gemäß einem bevorzugten Ausführungsbeispiel der vorliegenden Erfindung.

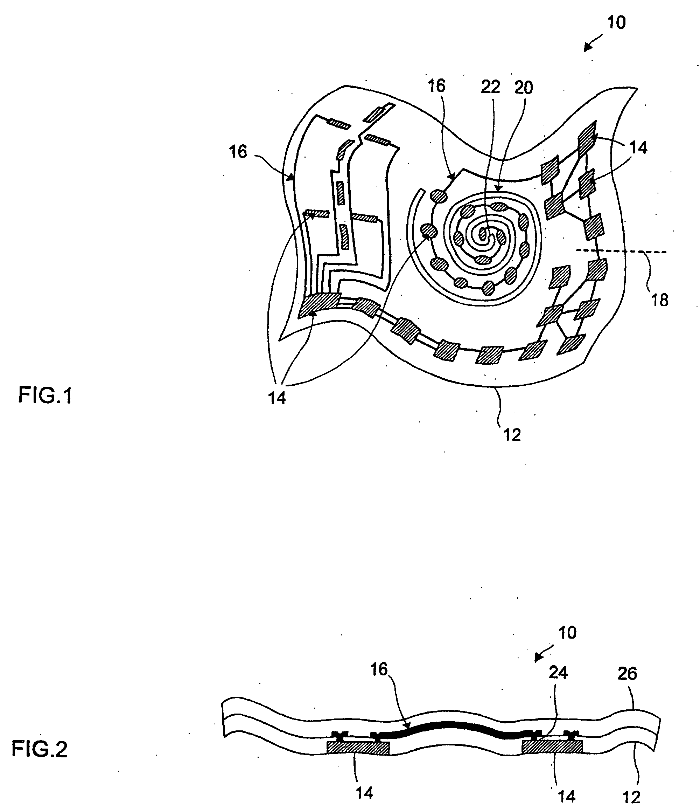

Fig. 1 zeigt eine Draufsicht auf ein Mikrosystem 10 gemäß der vorliegenden Erfindung. Das Mikrosystem 10 umfaßt eine flexible Folie 12, in der eine Mehrzahl von Halbleiterelementen 14 eingebettet ist. Die Halbleiterelemente 14 sind mittels Verbindungsleitungen 16 miteinander verbunden, die entweder als übliche Leiterbahnen ausgeführt sein können oder auch als komplexe Busstrukturen.

Vorzugsweise sind die Halbleiterelemente kleine Stücke aus einkristallinem Halbleitermaterial, die, wie es aus Fig. 1 zu sehen ist, in beliebiger Anordnung in der flexiblen Folie eingebettet werden können. Die Halbleiterelemente können integrierte aktive und/oder passive Bauelemente oder auch Sensoren oder Aktoren sein. Solche mikromechanischen Elemente sind in der Technik bekannt und werden nicht weiter beschrieben. Die flexible Folie 12 ist vorzugsweise eine sehr flexible Kunststoffolie, die beispielsweise aus einem Polymer bestehen kann.

Das Mikrosystem 10 gemäß der vorliegenden Erfindung ist aufgrund der Tatsache, daß die Halbleiterelemente 14 in der flexiblen Folie 12 eingebettet sind, außerordentlich flexibel und an beliebige Oberflächen anpaßbar. Um dem Mikrosystem 10 zusätzliche Flexibilität zu bieten, ist es günstig, einzelne Halbleiterelemente 14 in Funktionsgruppen anzuordnen, wie es beispielsweise in Fig. 1 rechts zu sehen ist. Dabei sind die Halbleiterelemente einer Funktionsgruppe rechts oben angeordnet, während die Halbleiterelemente einer weiteren Funktionsgruppe rechts unten angeordnet sind. Das Mikrosystem weist durch die Anordnung der Halbleiterelemente rechts in Fig. 1 um eine Linie 18 eine höhere Flexibilität auf als um eine zur Linie 18 senkrechten Linie. Das Mikrosystem erhält somit allein durch die Anordnung der Halbleiterelemente eine lokale Steifigkeit. Dies ist besonders dann vorteilhaft, wenn das Mikrosystem 10 um die Linie 18 gebogen bzw. gerollt werden soll, um an einen Körper mit beliebiger Gestalt angepaßt zu werden.

Eine weitere Möglichkeit, der flexiblen Folie eine lokale Steifigkeit bzw. lokale Flexibilität zu verschaffen, besteht in einer geometrischen Unterstrukturierung 20, die beispielsweise als beliebig geformte Verstärkungsrippen in der flexiblen Folie implementiert werden kann. Die spiralförmige geometrische Unterstrukturierung 20 ermöglicht es, daß das Mikrosystem 10 derart lokal flexibel ist, daß ein mit 22 bezeichneter Bereich des Mikrosystems aus der Zeichenebene heraus deformiert werden kann, um eine Art "Spitzhut" zu bilden. Dagegen ist das Mikrosystem 10 aufgrund der geometrischen Unterstrukturierung 20 im Bereich 22 gegen ein Falten um eine Linie in der Ebene des Mikrosystems 10 relativ steif. Weitere geometrische Unterstrukturierungen mit einfacherer Form könnten im Vorsehen von beispielsweise bezüglich Fig. 1 horizontalen Rippen parallel zur Linie 18 bestehen, wodurch, wenn mehrere parallel angeordnete derartige Horizontalrippen vorhanden sind, ein Falten lediglich um die Linie 18 möglich sein wird, jedoch kein Falten um eine Linie senkrecht zur Linie 18. Aufgrund der Gestaltungseigenschaften für flexible Folien können somit beliebige lokale Flexibilitäten eingestellt werden, um das Mikrosystem 10 gemäß der vorliegenden Erfindung an beliebige Untergründe anzupassen, oder um dasselbe in beliebig erwünschte Formen zu bringen.

Eine weitere Möglichkeit, um das Mikrosystem 10 lokal flexibel zu gestalten, besteht darin, die flexible Folie durch lokal unterschiedliche Polymeraushärtung mit einer anisotropen Steifigkeit zu versehen. Vorzugsweise wird ferner die Biegesteifigkeit der Halbleiterelemente 14 aus beispielsweise einkristallinem Silizium zumindest doppelt so groß und vorzugsweise um mindestens zwei bis drei Größenordnungen größer als die der flexiblen Kunststoffolie gesetzte Dadurch wird erreicht, daß die bei einer Verbiegung auftretenden mechanischen Spannungen überwiegend auf die flexible Kunststoffolie beschränkt sind und die elektronisch aktiven Komponenten des Mikrosystems 10 weitestgehend streßfrei bleiben, um piezoresistive Beeinflussungen der elektrischen Parameter dieser Halbleiterelemente 14 zu verhindern. Bei anderen Anwendungen, bei denen aktive Gebiete besonders empfindlich auf Streßeinwirkungen reagieren sollen,. wie beispielsweise bei einem Berührungssensor, können die genannten Möglichkeiten zur Steifigkeits- bzw. Flexibilitätseinstellung invers eingesetzt werden, um eine möglichst große Empfindlichkeit auf mechanische Belastungen oder Verschiebungen zu erhalten.

Fig. 2 zeigt ein bevorzugtes Ausführungsbeispiel des Mikrosystems 10 im Querschnitt. In Fig. 2 ist deutlich zu sehen, wie die Halbleiterelemente 14 in der flexiblen Folie 12 eingebettet sind bzw. wie die Verbindungsleitung 16 auf der flexiblen Folie 12 aufgebracht ist. Wenn sich die flexible Folie über die Vorderseite der Halbleiterelemente 14 hinaus erstreckt, werden in derselben Kontaktlöcher 24 erzeugt, um die Verbindungsleitung 16 mit Kontaktbereichen der Halbleiterelemente 14 zu kontaktieren. Zur Verbesserung der mechanischen Stabilität und zur Isolation ist über der Verbindungsleitung 16 eine weitere flexible Folie 26 aufgebracht, durch die die Verbindungsleitung 16 sandwichmäßig zwischen der flexiblen Folie 12 und der flexiblen Folie 26 aufgenommen wird.

Im nachfolgenden wird das erfindungsgemäße Verfahren zum Herstellen eines Mikrosystems beschrieben. Ausgehend von einem Halbleiterwafer, der vorzugsweise ein SIMOX-Wafer mit einer dünnen Halbleiterdeckschicht ist, welche vorzugsweise aus einkristallinem Silizium besteht und eine Dicke von z. B. einigen 100 nm aufweist, kann optional beispielsweise mittels Epitaxie eine einkristalline Siliziumschicht von einigen Mikrometern Dicke aufgewachsen werden. Auf diesem dünnen einkristallinen Siliziumfilm können nun die elektronischen Komponenten, welche für das Mikrosystem benötigt werden, in geeigneter Anordnung integriert werden. Im Extremfall kann eine solche elektronische Komponente nur noch aus einem einzigen Transistor oder einer kleinen Transistorgruppe bestehen. Im anderen Extremfall kann eine solche Komponente ein ganzer mikromechanischer Sensor oder Aktor sein. Durch Wegätzen der nicht mehr benötigten Halbleitergebiete zwischen den elektronischen Komponenten entstehen viele kleine, nach allen Seiten isolierte Stücke aus vorzugsweise einkristallinem Silizium, die bisher als Halbleiterelemente 14 bezeichnet wurden. Diese Halbleiterelemente 14 sind jedoch noch mittels des SIMOX-Wafers untereinander mechanisch verbunden. Ein Schritt des Freiätzens bewirkt, daß die einzelnen Halbleiterelemente 14 von der Oberfläche des Wafers vorstehen, da die dazwischenliegenden, nicht benötigten Gebiete weggeätzt wurden. Auf diese Oberfläche des Wafers, aus der die Halbleiterelemente 14 vorstehen, wird nun eine flexible Folie 12 aufgebracht, welche vorzugsweise als Polymermembran ausgeführt ist. Die Dicke der Folie wird von allgemeinen Stabilitätskriterien abhängen, die auch vom speziellen Einsatzgebiet des Mikrosystems bestimmt sind. Nach Aushärten der flexiblen Folie 12 wird die Verbindungsleitung 16 bzw. bei einem größeren Mikrosystem wie in Fig. 1 eine Vielzahl von Verbindungsleitungen auf die flexible Folie 12 aufgebracht. Wie es bereits erwähnt wurde, können Kontaktlöcher vorgesehen sein, wenn die Dicke der flexiblen Folie 12 größer als die Dicke der Halbleiterelemente 14 ist. Zur weiteren Erhöhung der Stabilität und Passivierung wird nach dem Aufbringen der Leiterbahnen die weitere flexible Folie 26 direkt auf die Verbindungsleitungen bzw. auf die erste flexible Folie 12 aufgebracht. Das Mikrosystem liegt nun in Form einer dielektrisch isolierten Sandwich-Struktur vor, wobei die Halbleiterelemente 14 in das Polymer eingebettet sind. Eine Mehrlagenmetallisierung ist im Bedarfsfall durch wiederholte Anwendung der Sandwichtechnik und durch Einfügen von Köntaktlöchern möglich. Die weitere flexible Folie 26 kann zum Einstellen der mechanischen Spannungsverteilung und somit zum Einstellen bzw. Schaffen einer lokalen Flexibilität bzw. Steifheit ebenfalls unterstrukturiert werden. Das erfindungsgemäße freitragende Mikrosystem wird schließlich durch Freiätzen des Trägerwafers in einem naßchemischen Ätzschritt erreicht. Dabei wird der Wafer von seiner Rückseite aus vollständig weggeätzt, derart, daß nur noch die Halbleiterelemente 14 zurückbleiben, die lediglich noch durch die flexible Folie und in geringem Maße durch die Verbindungsleitungen miteinander mechanisch verbunden sind.

Das erfindungsgemäße Mikrosystem, das auch als intelligente ultraflexible Folie bezeichnet wird, ermöglicht es, den Anwendungsbereich der Mikrosystemtechnik zu erweitern. Dies betrifft zum einen den Einsatz der Chips in nicht-ebenen Umgebungen. Zum anderen erlaubt die gewonnene mechanische Flexibilität der Struktur den Aufbau von dreidimensionalen Chipgeometrien, die mit den konventionellen planaren Strukturen nicht realisierbar sind, und die für die Sensorik sowie Aktorik völlig neue Möglichkeiten eröffnen. Zusätzlich sind solche mechanisch flexiblen Chips geradezu ideal für die Medizintechnik, wenn es z. B. notwendig ist, die traumatische Einwirkung von Implantaten auf das biologische Gewebe zu minimieren. Diesbezüglich existiert ein großer Bedarf im Bereich von implantierbaren intelligenten, d. h. mit integrierten Schaltungen ausgestatteten, Prothesen. Das erfindungsgemäße Mikrosystem eignet sich somit ausgezeichnet für eine Kopplung zwischen einem elektronischen und einem biologischen System. Weitere biologische Anwendungen sind beispielsweise in dem Einsatz des Mikrosystems als künstliche Netzhaut, als Nervenstimulator oder als Nervenkontakt zu sehen.

## Patentansprüche

1. Mikrosystem (10) mit folgenden Merkmalen:
einer flexiblen Folie (12);
einer Mehrzahl von Halbleiterelementen (14), die in der flexiblen Folie (12) eingebettet sind, wobei die flexible Folie (12) die Halbleiterelemente (14) trägt und kein starrer Träger vorhanden ist; und
mindestens einer im wesentlichen auf der flexiblen Folie (12) angeordneten Verbindungsleitung (16) zum elektrischen Verbinden von zumindest zwei Halbleiterelementen (14).

2. Mikrosystem (10) gemäß Anspruch 1, bei dem die Halbleiterelemente (14) derart bezüglich der Folie (12) angeordnet sind, daß das Mikrosystem (10) eine lokal unterschiedliche Flexibilität aufweist.

3. Mikrosystem (10) gemäß Anspruch 1 oder 2, bei dem die flexible Folie (12) geometrisch unterstrukturiert ist (20), derare, daß das Mikrosystem (10) eine lokal unterschiedliche Flexibilität aufweist.

4. Mikrosystem (10) gemäß einem der vorhergehenden Ansprüche, bei dem die flexible Folie eine lokal anisotrope Steifigkeit aufweist, derart, daß das Mikrosystem (10) eine lokal unterschiedliche Flexibilität aufweist.

5. Mikrosystem (10) gemäß einem der vorhergehenden Ansprüche, bei dem die Steifigkeit der Halbleiterelemente (14) zumindest doppelt so groß wie die Steifigkeit der flexiblen Folie (12) ist.

6. Mikrosystem (10) gemäß einem der vorhergehenden Ansprüche, bei dem zumindest einige der Halbleiterelemente (14) aus einkristallinem Silizium bestehen.

7. Mikrosystem (10) gemäß einem der vorhergehenden Ansprüche, bei dem die Halbleiterelemente (14) im wesentlichen flach sind und eine Abmessung senkrecht zur flachen Seite von wenigen Mikrometern bis in den Submikrometerbereich haben.

8. Mikrosystem (10) gemäß einem der vorhergehenden Ansprüche, bei dem die Mehrzahl von Halbleiterelementen (14) passive und/oder aktive elektronische Schaltungen aufweist.

9. Mikrosystem (10) gemäß einem der vorhergehenden Ansprüche, bei dem die Mehrzahl von Halbleiterelementen (14) elektromechanische Mikrosensoren und/oder Mikroaktoren aufweist.

10. Mikrosystem (10) gemäß einem der vorhergehenden Ansprüche, bei dem die Verbindungsleitung (16) eine Leiterbahn zwischen zwei Halbleiterelementen (14) oder eine Busstruktur ist, die eine Mehrzahl von Halbleiterelementen verbindet.

11. Mikrosystem (10) gemäß einem der vorhergehenden Ansprüche, bei dem die flexible Folie (12) ein Polymermaterial aufweist.

12. Mikrosystem (10) gemäß einem der vorhergehenden Ansprüche, bei dem an aktiven Gebieten im Vergleich zu Nachbargebieten eine niedrige lokale Steifigkeit vorliegt, um eine lokale Empfindlichkeit des Mikrosystems auf Verformungen zu implementieren.

13. Mikrosystem (10) gemäß einem der vorhergehenden Ansprüche, bei dem die Halbleiterelemente in der flexiblen Folie derart aufgenommen sind, daß sie bis auf eine Hauptoberfläche von der flexiblen Folie umschlossen sind, und bei dem die Verbindungsleitung (16) auf der Folie aufgebracht ist und die Halbleiterelemente (14) durch Kontaktlöcher (24) in der Folie kontaktiert sind.

14. Mikrosystem (10) gemäß Anspruch 13, bei dem über der Verbindungsleitung (16) eine weitere flexible Folie (26) aufgebracht ist, derart, daß die Verbindungsleitung (16) zwischen der flexiblen Folie (12), in der die Halbleiterelemente (14) eingebettet sind, und *der wei*teren flexiblen Folie (26) in einer Sandwich-Struktur angeordnet ist.

15. Mikrosystem (10) gemäß Anspruch 14, das eine mehrschichtige Struktur aufweist, wobei mehrere Verbindungsleitungsschichten jeweils durch flexible Folien getrennt sind, und wobei die Halbleiterelemente (14) und Verbindungsleitungen einzelner Schichten über Kontaktlöcher in entsprechenden flexiblen Folien elektrisch miteinander verbunden sind.

16. Verfahren zum Herstellen eines Mikrosystems (10) mit folgenden Schritten:
Integrieren von elektronischen Komponenten in eine Halbleiterschicht, die auf einer Waferoberfläche vorhanden ist, derart, daß zumindest zwei elektronische Komponenten an räumlich unterschiedlichen Stellen in dem Wafer angeordnet sind;
Freiätzen der Bereiche zwischen den elektronischen Komponenten, wodurch mit dem Wafer verbundene, von demselben vorstehende Halbleiterelemente (14) erzeugt werden;
Aufbringen einer flexiblen Folie (12) auf die Waferoberfläche, derart, daß die Halbleiterelemente (14) in der flexiblen Folie eingebettet sind;
Aufbringen einer Verbindungsleitung (16) auf die flexible Folie (12), derart, daß die Verbindungsleitung (16) mit Kontaktbereichen von Halbleiterelementen (14) verbunden ist; und
Wegätzen des Wafers von der Waferrückseite aus, derart, daß die Halbleiterelemente (14) nicht mehr durch den Wafer mechanisch untereinander verbunden sind und die Halbleiterelemente (14) durch die flexible Folie (12) gehalten werden, wobei kein starrer Träger vorhanden ist.

17. Verfahren gemäß Anspruch 16, bei dem die elektronischen Komponenten in Funktionsgruppen in die Halbleiterschicht geätzt werden, damit das Mikrosystem (10) eine lokal unterschiedliche Flexibilität aufweist.

18. Verfahren gemäß Anspruch 16 oder 17, das ferner den Schritt des geometrischen Unterstrukturierens (20) der Folie (12) aufweist, wodurch die Folie (12) eine lokal unterschiedliche Flexibilität aufweist.

19. Verfahren gemäß einem der Ansprüche 16 bis 18, das ferner den Schritt des Erzeugens einer lokal unterschiedlichen Steifigkeit der Folie (12) aufweist.

20. Verfahren gemäß einem der Ansprüche 16 bis 19, das ferner den Schritt des Aufbringens einer weiteren flexiblen Folie (26) über der Verbindungsleitung (16) aufweist.

## Claims

1. A microsystem (10) comprising:
a flexible foil (12);
a plurality of semiconductor elements (14) embedded in said flexible foil (12); and
at least one connection line (16) arranged substantially on said flexible foil (12) and used for electrically connecting at least two semiconductor elements (14).

2. A microsystem (10) according to claim 1, wherein the semiconductor elements (14) are arranged with respect to said foil (12) in such a way that the microsystem (10) has locally different degrees of flexibility.

3. A microsystem (10) according to claim 1 or 2, wherein the flexible foil (12) is geometrically substructured (20) in such a way that the microsystem (10) has locally different degrees of flexibility.

4. A microsystem (10) according to one of the preceding claims, wherein the flexible foil has a locally anisotropic stiffness of such a nature that the microsystem (10) has locally different degrees of flexibility.

5. A microsystem (10) according to one of the preceding claims, wherein the semiconductor elements (14) are at least twice as stiff as the flexible foil (12).

6. A microsystem (10) according to one of the preceding claims, wherein at least some of the semiconductor elements (14) consist of monocrystalline silicon.

7. A microsystem (10) according to one of the preceding claims, wherein the semiconductor elements (14) are essentially flat and have dimensions of a few micrometres down to the submicrometre range at right angles to the flat side.

8. A microsystem (10) according to one of the preceding claims, wherein the plurality of semiconductor elements (14) includes passive and/or active electronic circuits.

9. A microsystem (10) according to one of the preceding claims, wherein the plurality of semiconductor elements (14) includes electromechanical microsensors and/or microactuators.

10. A microsystem (10) according to one of the preceding claims, wherein the connection line (16) is a conducting track between two semiconductor elements (14) or a bus structure which connects a plurality of semiconductor elements.

11. A microsystem (10) according to one of the preceding claims, wherein the flexible foil (12) comprises a polymer material.

12. A microsystem (10) according to one of the preceding claims, wherein the local stiffness of active regions is lower than that of neighbouring regions so as to implement a local sensitiveness of the microsystem to deformations.

13. A microsystem (10) according to one of the preceding claims, wherein the semiconductor elements are accommodated in the flexible foil in such a way that they are enclosed by said flexible foil with the exception of a main surface, and wherein the connection line (16) is applied to the foil and the semiconductor elements (14) are contacted through via holes (24) in the foil.

14. A microsystem (10) according to claim 13, wherein an additional flexible foil (26) is applied on top of the connection line (16) in such a way that the connection line (16) is arranged in a sandwich structure between the flexible foil (12), in which the semiconductor elements (14) are embedded, and said additional flexible foil (26).

15. A microsystem (10) according to claim 14 having a multilayered structure, wherein several connection line layers are separated by respective flexible foils, and wherein the semiconductor elements (14) and the connection lines of individual layers are electrically connected to one another through via holes in respective flexible foils.

16. A method for producing a microsystem (10) comprising the following steps:
integrating electronic components in a semiconductor layer, which is provided on a wafer surface, in such a way that at least two electronic components are arranged at locally different positions in the wafer;
etching the areas between said electronic components free; whereby semiconductor elements (14) connected to the wafer and projecting beyond said wafer are produced;
applying a flexible foil (12) to the wafer surface in such a way that the semiconductor elements (14) are embedded in said flexible foil;
applying a connection line (16) to the flexible foil (12) in such a way that said connection line (16) is connected to contact areas of semiconductor elements (14); and
etching the wafer away from the back of said wafer in such a way that the semiconductor elements (14) are no longer mechanically interconnected by said wafer.

17. A method according to claim 16, wherein the electronic components are etched into the semiconductor layer in functional groups so as to impart locally different degrees of flexibility to the microsystem (10).

18. A method according to claim 16 or 17 including the additional step of substructuring (20) the foil (12), whereby said foil (12) has imparted thereto locally different degrees of flexibility.

19. A method according to one of the claims 16 to 18, including the additional step of producing locally different degrees of stiffness of the foil (12).

20. A method according to one of the claims 16 to 19, including the additional step of applying an additional flexible foil (26) on top of the connection line (16).

## Revendications

1. Microsystème (10) aux caractéristiques suivantes :
un film flexible (12) ;
une pluralité d'éléments semi-conducteurs (14) enrobés dans le film flexible (12), le film flexible (12) portant les éléments semi-conducteurs (14) et aucun porteur rigide n'étant présent ; et
au moins une ligne de connexion (16) disposée sensiblement sur le film flexible (12) pour la connexion électrique d'au moins deux éléments semi-conducteurs (14).

2. Microsystème (10) selon la revendication 1, dans lequel les éléments semi-conducteurs (14) sont disposés par rapport au film (12) de telle sorte que le microsystème (10) présente une flexibilité localement différente.

3. Microsystème (10) selon la revendication 1 ou 2, dans lequel le film flexible (12) est géométriquement sous-structuré (20), de sorte que le microsystème (10) présente une flexibilité localement différente.

4. Microsystème (10) selon l'une des revendications précédentes, dans lequel le film flexible présente une rigidité localement anisotrope.

5. Microsystème (10) selon l'une des revendications précédentes, dans lequel la rigidité des éléments semi-conducteurs (14) est au moins deux fois plus grande que la rigidité du film flexible (12).

6. Microsystème (10) selon l'une des revendications précédentes, dans lequel au moins quelques-uns des éléments semi-conducteurs (14) sont en silicium monocristallin.

7. Microsystème (10) selon l'une des revendications précédentes, dans lequel les éléments semi-conducteurs (14) sont sensiblement plats et ont une dimension, perpendiculairement au côté plat, de quelques micromètres jusqu'à moins d'un micromètre.

8. Microsystème (10) selon l'une des revendications précédentes, dans lequel la pluralité d'éléments semi-conducteurs (14) présente des circuits électroniques passifs et/ou actifs.

9. Microsystème (10) selon l'une des revendications précédentes, dans lequel la pluralité d'éléments semi-conducteurs (14) présente des microdétecteurs et/ou des micro-actuateurs électromécaniques.

10. Microsystème (10) selon l'une des revendications précédentes, dans lequel la ligne de connexion (16) est un chemin de conducteurs entre deux éléments semi-conducteurs (14) ou une structure de collecteur qui relie une pluralité d'éléments semi-conducteurs.

11. Microsystème (10) selon l'une des revendications précédentes, dans lequel le film flexible (12) présente un matériau polymère.

12. Microsystème (10) selon l'une des revendications précédentes, dans lequel est présente dans les zones actives une rigidité locale plus faible que dans les zones avoisinantes, afin de mettre en oeuvre une sensibilité locale du microsystème aux déformations.

13. Microsystème (10) selon l'une des revendications précédentes, dans lequel les éléments semi-conducteurs (14) sont repris dans le film flexible de telle sorte que, à l'exception d'une surface principale, ils soient entourés par le film flexible et dans lequel la ligne de connexion (16) est appliquée sur le film et les éléments semi-conducteurs (14) sont mis en contact par des trous de contact (24) dans le film.

14. Microsystème (10) selon la revendication 13, dans lequel est placé, sur la ligne de connexion (16), un autre film flexible, de sorte que la ligne de connexion (16) soit disposée entre le film flexible (12) dans lequel sont enrobés les éléments semi-conducteurs (14) et l'autre film flexible (26), en forme de structure en sandwich.

15. Microsystème (10) selon la revendication 14, présentant une structure multicouche, plusieurs couches de lignes de connexion étant séparées, chacune, par des films flexibles, et dans lequel les éléments semi-conducteurs (14) et les lignes de connexion des différentes couches sont reliés électriquement entre eux par des trous de contact dans des films flexibles correspondants.

16. Procédé de fabrication d'un microsystème (10), aux étapes suivantes consistant à :
intégrer des composants électroniques dans une couche semi-conductrice qui est présente sur une surface de plaquette, de sorte qu'au moins deux composants électroniques soient disposés à des endroits spatialement différents dans la plaquette ;
dégager par gravure les zones entre les composants électroniques, d'où il est généré des éléments semi-conducteurs (14) assemblés avec la plaquette et faisant saillie par rapport à cette dernière ;
application d'un film flexible (12) sur la surface de la plaquette, de sorte que les éléments semi-conducteurs (14) soient enrobés dans le film flexible ;
application d'une ligne de connexion (16) sur le film flexible (12), de sorte que la ligne de connexion (16) soit reliée à des zones de contact d'éléments semi-conducteurs (14); et
éliminer la plaquette par gravure, depuis le côté arrière de la plaquette, de sorte que les éléments semi-conducteurs (14) ne soient plus reliés mécaniquement l'un à l'autre par la plaquette et que les éléments semi-conducteurs (14) soient maintenus par le film flexible (12), aucun support rigide n'étant présent.

17. Procédé selon la revendication 16, dans lequel les composants électroniques sont gravés en groupes fonctionnels dans la couche semi-conductrice, afin que le microsystème (10) présente une flexibilité localement différente.

18. Procédé selon la revendication 16 ou 17, présentant, par ailleurs, l'étape consistant à sous-structurer géométriquement (20) le film (12), d'où le film (12) présente une flexibilité localement différente.

19. Procédé selon l'une des revendications 16 à 18, présentant, par ailleurs, l'étape consistant à générer une flexibilité localement différente du film (12).

20. Procédé selon l'une des revendications 16 à 19, présentant, par ailleurs, l'étape consistant à appliquer un autre film flexible (26) sur la ligne de connexion (16).
